Europäisches Patentamt

(19) European Patent Office

Office européen des brevets

(11) Publication number: 0 154 451
A2

(12) # EUROPEAN PATENT APPLICATION

(21) Application number: 85301165.8

(22) Date of filing: 21.02.85

(51) Int. Cl.⁴: H 01 L 31/02
H 01 L 31/06

(30) Priority: 24.02.84 US 582984

(43) Date of publication of application:
11.09.85 Bulletin 85/37

(84) Designated Contracting States:
BE CH DE FR GB IT LI LU NL SE

(71) Applicant: ENERGY CONVERSION DEVICES, INC.
1675 West Maple Road
Troy Michigan 48084(US)

(72) Inventor: McGill, John
227 Old Perch Road
Rochester Michigan, 48063(US)

(74) Representative: Jackson, Peter Arthur et al,
GILL JENNINGS & EVERY 53-64 Chancery Lane
London WC2A 1HN(GB)

(54) Photoresponsive semiconductor device having a double layer anti-reflective coating.

(57) An improved dual layer anti-reflective coating for use in a photoresponsive semiconductor device (12c) is disclosed. The coating has a low parasitic absorbance in the range of about 475 to 600 nanometers. The dual layer has an incident light layer (22) and an intermediate layer (20c). The light incident layer may be a transparent conductive oxide. The intermediate layer is formed of a silicon alloy including at least one band gap energy widening element and may be the outermost layer of the device. The intermediate layer has an index of refraction between the indices of refraction of the incident light layer and the underlying photoresponsive semiconductor device. The relative thicknesses of the incident light layer and intermediate layer are chosen to maximise the amount of light transmitted to the photoresponsive device.

FIG 1

Croydon Printing Company Ltd.

ENERGY CONVERSION DEVICES, INC.        Ref: 50/2605/62 0154451

### PHOTORESPONSIVE SEMICONDUCTOR DEVICE
### HAVING A DOUBLE LAYER ANTI-REFLECTIVE COATING

Photoresponsive devices, such as photovoltaic cells, photodetectors, photoconductors, and the like depend on incident light, frequently within a narrow bandwidth, for efficient operation. These devices usually are coated with substantially transparent films, or layers, for example, conducting electrodes and contacts. These coatings may transmit, reflect or absorb incident light. The amount of light transmitted through the coating to the device is the incident light minus the sum of the reflected and absorbed light. The total loss of light from reflection and absorption is referred to here as parasitic absorption. Apparently transparent films, coatings and layers all exhibit parasitic absorption reducing the efficiency of an underlying photoresponsive device.

There exists a need for an anti-reflection coating that widens the bandwidth of light transmitted to an underlying photoresponsive device, and a method of forming such coatings on semiconductor devices that will not diminish the desirable photoresponsive properties of the semiconductor material of the semiconductor device. This need is especially great in large-area photovoltaic cells, where a small decrement in output per unit area, multiplied over a large area, represents a large absolute loss of output due to parasitic light absorption.

One attempt to reduce parasitic absorption is disclosed in U.S. Patent 4,389,534 to Winterling for Amorphous Silicon Solar Cell Having Improved Antireflection Coating. There, a layer of polycrystalline silicon is interposed between a transparent conductive oxide layer and an amorphous silicon photoresponsive device. Deposition of the polycrystalline layer introduces processing steps into the fabrication of the device that could convert underlaying amorphous silicon to polycrystalline or micro-crystalline form.

Another method of improving photoresponsive of p-i-n cells is disclosed in U.S. Patent 4,388,482 to Hamakawa et al. for High-Voltage Photovoltaic Cell Having a Heterojunction of Amorphous Semiconductor and Amorphous Silicon. There, a nitrogen or carbon alloy of amorphous silicon having a band gap energy greater than 1.85 electron volts forms a light receiving layer that is one element of a p-i-n amorphous silicon device. A transparent conductive oxide forms an electrode on top of the light receiving layer.

In the present invention a dual layer coating is formed on the device for substantially reducing parasitic optical absorption while broadening the bandwidth of the transmitted light. The coating is characterized by a light incident layer and a layer intermediate the light incident layer and the underlying photoresponsive semiconductor materials. The intermediate layer may be the outermost photoresponsive layer of the photoresponsive semiconductor device. The intermediate layer has an index of refraction, measured at 550 nanometers, that is greater than the index of refraction of the light incident layer and less than that of the semiconductor photoresponsive device material. The intermediate layer is preferably formed of a silicon alloy material including a band gap energy widening element for increasing its band gap energy over that of the material of the underlying photoresponsive device and for decreasing its index of refraction. The concentration of the band gap energy widening element is preferably chosen to optimize the index of refraction and electrical conductivity. The thicknesses and indices of refraction of the light incident layer and the intermediate layer are adjusted to increase the bandwidth of the incident light that is transmitted to the underlying device, for example, from the prior art bandwidth of 525 to 575 nanometers to a bandwidth of approximately 475 to 600 nanometers.

Figure 1 is a fragmentary, cross-sectional view of a tandem photovoltaic cell comprising a plurality of p-i-n type cells.

Figure 2 is a fragmentary plan view of a large-area photovoltaic device comprising a plurality of small-area isolated cells.

Figure 3 is a graph of wavelength versus reflection for a dual layer anti-reflective coating according to the invention.

Figure 4 is a graph of nitrogen content in a deposition gas versus bandgap for a silicon alloy deposited from the gas and useful in providing one layer of a dual layer anti-reflective coating according to the invention.

Figure 5 is a graph of nitrogen content in a deposition gas versus electrical conductivity for a silicon alloy deposited from the gas and useful in providing one layer of a dual layer anti-reflective coating according to the invention.

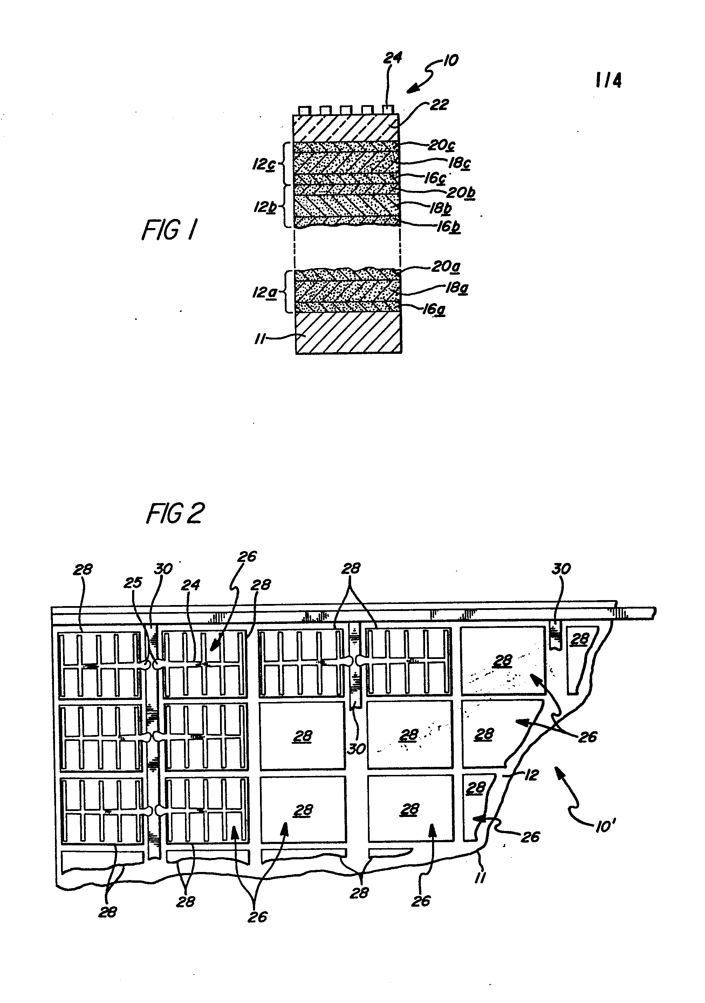

Figure 1 shows a p-i-n type photovoltaic device 10, such as a solar cell, made up of individual p-i-n type cells 12a, 12b and 12c. A substrate 11 on cell 12a forms a surface of cell 10 and functions as an electrode. Substrate 11 may be transparent or formed from a metallic material such as stainless steel, aluminum, tantalum, molybdenum or chromium, with or without an insulating layer thereon, or an insulating material such as glass with or without metallic particles embedded therein or may be a reflector. The term, "substrate" includes a flexible film and any elements added to it by preliminary processing. Each of cells, 12a, 12b and 12c are preferably fabricated from an amorphous semiconductor body containing at least a silicon or germanium alloy. Each of the semiconductor bodies includes an n-type conductivity semiconductor layer 20a, 20b and 20c, an intrinsic semiconductor layer 18a, 18b and 18c, and a p-type conductivity semiconductor layer 16a, 16b and 16c. As illustrated, cell 12b is an intermediate cell and, as indicated in Figure 1, additional intermediate cells may be stacked on the illustrated cells without departing from the spirit or scope of the present invention. A TCO (transparent conductive oxide) layer 22, formed in the preferred embodiment of indium tin oxide, deposited on cell 12c forms an electrode and surface of device. A metallic electrode grid 24 may be applied to layer 22 to shorten the charge carrier path through the TCO and increase conduction efficiency.

Figure 2 is a fragmentary plan view of a large-area photovoltaic device 10' generally similar to the device depicted in cross section in Figure 1. Large-area device 10' includes a continuous, large-area substrate 11 bearing a continuous layer of semiconductor material 12. A plurality of electrically isolated portions 26 of material 12 contribute to the total electrical output of large-area device 10'. Each of isolated portions 26 share common continuous substrate 11. Electrically isolated portions 26 of semiconductor material 12 are formed by discrete regions 28 of the TCO material that has been deposited on semiconductor material 12 to form an electrode of each small-area photovoltaic cell 26. Each small-area cell 26 is electrically isolated from the adjacent small-area cells because relatively high conductivity layer 22 collects current from the underlying semiconductor material, while the high lateral electrical resistivity of semiconductor material 12 restricts lateral current flow between discrete regions 26. Grid 24 of each electrically isolated small area portion 26 is connected to a system of busbars 30 to convey photogenerated current to a central collection point. Grids 24 are connected to busbars 30 by connectors 25, such as dots of silver paste. In some applications it is desirable not to connect a grid 24 to busbars 30 until the underlying portion 26 is tested and found to be electrically operative.

The dual layer anti-reflective coating of the invention incorporates a light incident layer, such as TCO layer 22 and an intermediate layer 20c which is the outermost layer of the photoresponsive semiconductor device. The anti-reflective coating is referred to as a dual layer coating because of the anti-reflective copperation between the light incident layer and semiconductor layer 20c beneath and in contact with it. Together, those layers substantially reduce parasitic optical absorption and broaden the bandwidth of the light reaching photoresponsive semiconductor material 18c.

Intermediate layer 20c is preferably an amorphous silicon alloy material including at least one band gap energy increasing element. Silicon alloy materials, such as Si:H:F, and Si:H:F:P, have a band gap energy of 1.7 to 1.8 electron volts and may be prepared by the glow discharge deposition of a deposition gas mixture containing

- 5 -          0154451

$SiF_4$, $PH_3$, $H_2$, and $N_2$. The preferred silicon alloy material for intermediate layer 20c is a nitrogenated, phosphine doped, silicon alloy, Si:H:F:N:P, having a band gap energy of 2.0 to 2.4 electron volts, sufficient electrical conductivity to allow current flow between incident layer 22, electrode grid 24, and photoresponsive semiconductor device 12c without undue power loss, and an index of refraction intermediate the indices of refraction of incident layer 22 and layer 18c of photoresponsive semiconductor device 12c.

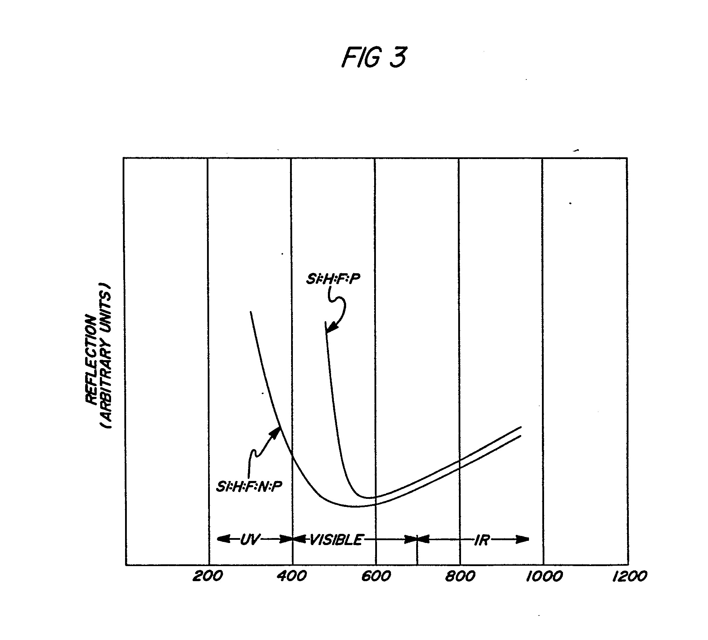

Proper selection of the relative thicknesses of incident layer 22 and intermediate layer 20c, and the indices of refraction of incident layer 22, intermediate layer 20c, and layer 18c of semiconductor device 12c, allows additional light energy in the optimum operating range of photoresponsive semiconductor device 12c to reach layer 18c by two different mechanisms. First, parasitic optical absorption is reduced. Second, the bandwidth of incident light reaching layer 18c is broadened, for example, from a 522 to 575 nanometer range to a 475 to 600 nanometer range. The bandwidth broadening mechanism is illustrated in Figure 3, comparing an Si:H::F:N:P layer of the invention with an Si:H:F:P layer, without local reflection minima, or transmission maxima, at, e.g. 520 and 555 nanometers, and without a local reflection maximum or transmission minimum therebetween, but with relatively uniform transmission therebetween, and without increased attenuation or parasitic absorption of red and near-infrared. Figure 3 shows the light reflection versus wavelength characteristics for a dual layer anti-reflective coating of the invention. As there shown, the reflection is relatively uniform in the 475-600 nanometer range, and is not attenuated in the red to near-infrared range with respect to an intermediate layer 20c of narrower band gap energy. At the same amount of reflection, the wavelength window with the prior art material extends only from about 525 to 575 nanometers. Intermediate layer 20c has an index of refraction less than the index of refraction of light incident layer 22 and greater than the index of refraction of the subjacent layer in contact with it, e.g., intrinsic type conductivity layer 18c. That is, the index of refraction of intermediate layer 20c is intermediate the indices of refraction of light incident layer 22 and semiconductor device 12c, including its intrinsic layer 18c.

Generally, when light incident layer 22 is a transparent conductive oxide, e.g. indium tin oxide, its index of refraction is about 1.8 to 2.0, and when intrinsic layer 18c is an intrinsic silicon alloy material, e.g. Si:H, its index of refraction is about 4.5 at 550 nanometers. Under these conditions, the preferred index of refraction for intermediate layer 20c is from about 2.5 to about 3.3, and preferably about 3.0, all measured at 550 nanometers. Preferably, the index of refraction of intermediate layer, 20c, should be the square root of the product of the indices of refraction of light incident layer 22 and intrinsic type conductivity layer 18c.

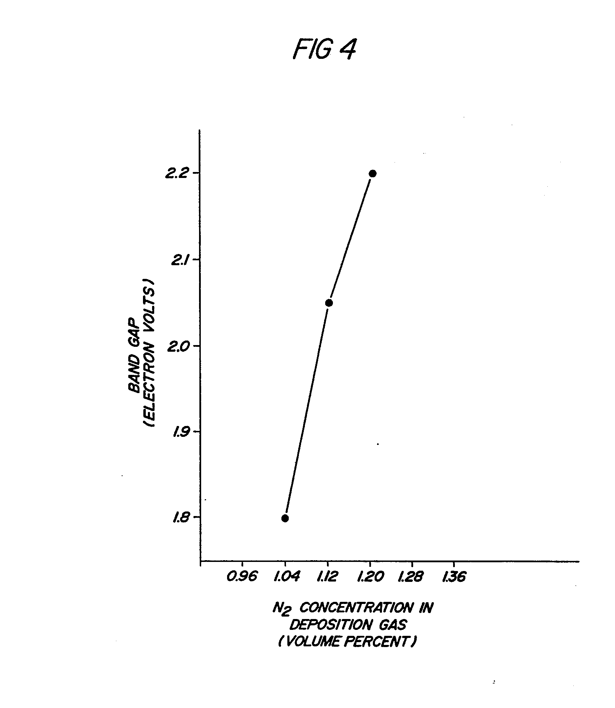

Figure 4 shows the band gap energy in electron volts of a silicon alloy, Si:H:F:N:P, as a function of nitrogen gas content in a deposition gas mixture used to deposit the alloy by a glow discharge process in a gas mixture of $SiF_4$, $PH_3$, $H_2$, and $N_2$. Nitrogen increases the band gap energy of the deposited silicon alloy used in intermediate layer 20c. The band gap energy of the silicon alloy of the intermediate layer should be as large as possible without loss of electrical conductivity, preferably between 2.0 and 2.4 electron volts, and preferably about 2.2 electron volts.

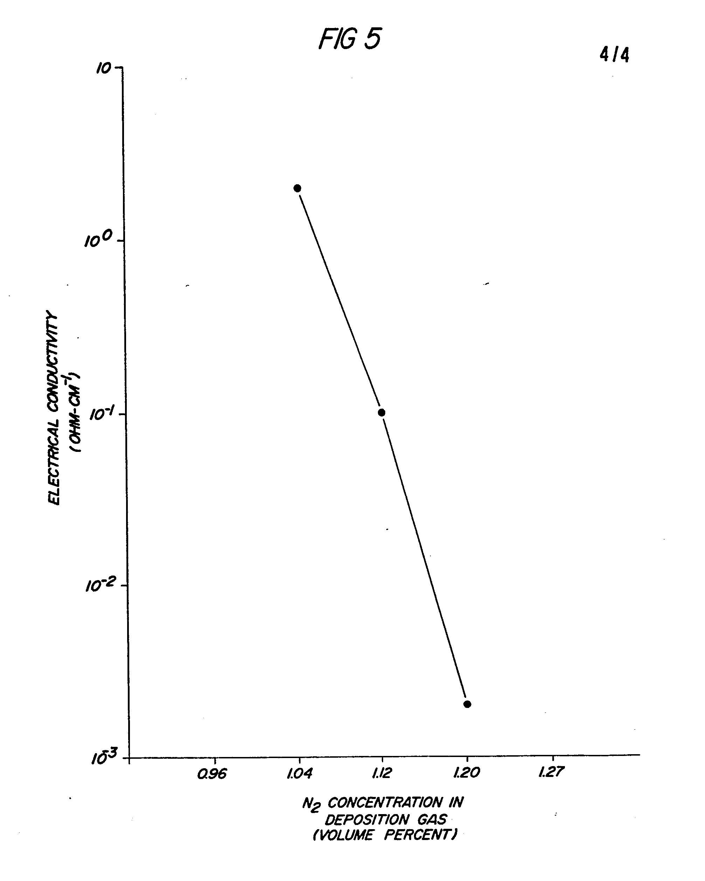

Figure 5 shows the electrical conductivity of a silicon alloy, Si:H:F:N:P, as a function of nitrogen gas content in a deposition gas mixture used to deposit the alloy by glow discharge deposition in a gas mixture of $SiF_4$, $PH_3$, $H_2$ and $N_2$. Increasing nitrogen in the deposition gas mixture reduces the electrical conductivity of the silicon alloy. Preferably the silicon alloy of intermediate layer 20c has an electrical conductivity greater than $10^{-5}$ $(ohm-cm)^{-1}$.

The relative thicknesses of the two elements 20c, 22 of the dual layer anti-reflective coating should take advantage of the indices of refraction, electrical conductivities, and band gaps of the two elements to obtain the desired wavelength versus absorption properties. Particularly good results have been found at an incident light layer thickness of about 45 to 50 nanometers and an intermediate layer thickness of about 15 to 25 nanometers and preferably about 20 nanometers.

Substrate 11 can be a reflector, e.g., a specular reflector or a diffuse reflector. With either type of reflector, light which has initially passed through active region 12 or regions, 12a, 12b, 12c of device 10, but which is unabsorbed or unused is redirected through active regions 12a, 12b, 12c of the device. This reflection provides increased photon absorption and charge carrier generation in active region or regions 12a, 12b, 12c providing increased short circuit currents. In the case of a specular reflector, the unused light is generally redirected for one additional pass through the device active regions 12a, 12b, 12c. In the case of a diffuse reflector, the light is redirected through the active regions 12a, 12b, 12c, at angles sufficient to substantially confine the redirected light within device 10. This confinement produces multiple reflections of the redirected light in active regions 12a, 12b, 12c. As a result, both specular and diffuse back reflectors 11 produce increased short circuit currents and increased efficiencies. When redirected light passes through active regions 12a, 12b, 12c multiple times, those regions can be made thinner to reduce charge carrier recombination while maintaining efficient charge carrier generation and collection.

## CLAIMS

1. In a photoresponsive semiconductor device (10) comprising a semiconductor layer (18c) having a first index of refraction and a first band gap energy, said device including an amorphous semiconductor layer (20c) for receiving light and deposited on the semiconductor layer, a dual layer anti-reflective coating including a light incident layer (22) deposited on said layer for receiving light (20c) having a second index of refraction less than said first index of refraction, said layer for receiving light (20) having an index of refraction intermediate said first and second indices of refraction and including at least one band gap energy increasing element, characterised in that the thicknesses of said light incident layer (22) and said layer for receiving light (20c) are chosen to optimise the amount of light transmitted to said device.

2. The device of claim 1 characterised in that said light incident layer (22) is a transparent conductive oxide 45 to 50 nanometers thick having an index of refraction of about 1.8 at a wavelength of 550 nanometers.

3. The device of claim 2 characterised in that said light recieving layer (20c) is 15 to 25 nanometers thick.

4. The device of claim 1 characterised in that said layer for receiving light (20c) is a silicon alloy containing nitrogen as a band gap energy increasing element.

5. The device of claim 4 characterised in that said light receiving layer (20c) has an index of refraction of about 2.5 to 3.3 at 550 nanometers.

6. The device of claim 4 characterised in that said layer for receiving light (20c) has a band gap of 2.0 to 2.4 electron volts.

7. A method of forming an improved photoresponsive semiconductor device including depositing a photoresponsive semiconductor layer (18c); depositing a layer of a first thickness of an amorphous silicon alloy (20c) on said photoresponsive semiconductor layer (18c), the silicon alloy including a band gap energy increasing element and having a lower index of refraction than said photoresponsive semiconductor layer (18c); and depositing a light incident layer (22) of a second thickness on said silicon alloy material (20c) having a lower index of refraction than said amorphous silicon alloy (20c), characterised in controlling said first and second thicknesses to optimise the amount of light transmitted to said photoresponsive semiconductor layer (18c).

8. The method of claim 7 characterised in depositing said silicon alloy (20C) in the presence of nitrogen to increase the band gap energy of said silicon alloy (20c).

9. The method of claim 7 characterised in depositing said silicon alloy (20c) to a thickness of 15 to 25 nanometers.

10. The method of claim 9 characterised in depositing a transparent conductive oxide as said light incident layer (22) to a thickness of 45 to 50 nanometers.

11. The method of claim 7 characterised in depositing said silicon alloy from a gas stream containing $SiF_4$, $H_2$, $N_2$, and $PH_3$ to form a silicon alloy having a hand gap energy of 2.0 to 2.4 electron volts.

0154451

1/4

FIG 1

FIG 2

FIG 3

FIG 4

BAND GAP
(ELECTRON VOLTS)

2.2

2.1

2.0

1.9

1.8

0.96   1.04   1.12   1.20   1.28   1.36

$N_2$ CONCENTRATION IN
DEPOSITION GAS
(VOLUME PERCENT)

FIG 5